# NEW EUROPEAN PATENT SPECIFICATION

(11) **EP 1 811 336 B2**
(45) Date of publication and mention of the opposition decision: **22.09.2021**
(45) Mention of the grant of the patent: 14.10.2015
(21) Application number: 05806234.0
(22) Date of filing: 10.11.2005
(51) Int. Cl.: G03F 7/00, G03F 7/033

(54) **PHOTOSENSITIVE RESIN COMPOSITION FOR FLEXOGRAPHIC PRINTING**
LICHTEMPFINDLICHE HARZZUSAMMENSETZUNG FÜR DEN FLEXOGRAFISCHEN DRUCK
COMPOSITION DE RESINE PHOTOSENSIBLE POUR IMPRESSION FLEXOGRAPHIQUE

(30) Priority: 11.11.2004 JP 2004327359
(43) Date of publication of application: 25.07.2007
(73) Proprietor: Asahi Kasei Chemicals Corporation, Tokyo 100-8440 (JP)
(72) Inventor: NAKANO, Katsuya, ASAHI KASEI KABUSHIKI KAISHA, Tokyo 1008440 (JP); ARAKI, Yoshifumi, ASAHI KASEI KABUSHIKI KAISHA, Tokyo 1008440 (JP); FUJIWARA, Masahiro, ASAHI KASEI KABUSHIKI KAISHA, Tokyo 1008440 (JP)
(74) Representative: D Young & Co LLP
(86) International application number: PCT/JP2005/020620
(87) International publication number: WO 2006/051863

(56) References cited:
- EP-A1- 0 224 442
- EP-A1- 0 778 297
- EP-A1- 0 856 772
- EP-A1- 0 972 796
- EP-A1- 1 473 595
- EP-A2- 0 740 214
- WO-A1-00/00546
- WO-A1-98/13730
- WO-A1-2005/031459
- JP-A- 05 501 457
- JP-A- 10 031 303
- JP-A- 10 287 817
- JP-A- 10 287 817
- JP-A- 11 249 305
- JP-A- H04 252 243
- JP-A- 2002 107 916
- JP-A- 2002 534 714
- US-A- 4 970 037
- US-A- 5 679 485
- US-A- 6 025 098
- US-B1- 6 326 127
- "Antioxidanten" In: "Römpp Chemie Lexikon, 9th edition", 1995 page 220,
- Hans Zweifel: "Plastics Additives Handbook, 5th edition", 2001, Hanser Publishers, Munich pages 64-71,98,104-105 and 109,

## Description

### [Technical Field]

The present invention relates to a production method of a photosensitive resin composition used for a flexographic printing plate.

### [Background Art]

The common photosensitive resin compositions for flexographic printing contain a thermoplastic elastomer, a photopolymerizable unsaturated monomer, and a photopolymerization initiator as described in Patent Documents 1, 2 and 3.

Photosensitive structural bodies for flexographic printing plates are generally formed by arranging the above-mentioned photosensitive resin composition onto a support such as a polyester film, and further as needed, arranging thereon a slip layer or a protection layer for smooth contact with a negative film or a UV shielding layer that contains an infrared-sensitive substance which can be cut by an infrared laser.

Flexographic printing plates are generally prepared from such a photosensitive structural body for flexographic printing plates by conducting first ultraviolet full exposure through a support (back exposure) to provide a thin uniform cured layer; conducting image exposure (relief exposure) to the surface of a photosensitive resin layer through a negative film or directly above the UV shielding layer; washing out unexposed parts with a developing solvent, or absorption removing with an absorbing layer after heat melting; and conducting post-exposure.

Photosensitive resin compositions have drawbacks in that they are difficult to mold due to poor flowability when compounded using a screw extruder, etc., and molded into a plate with a desired thickness by a calendering roll, etc. Moreover, photosensitive structural bodies for flexographic printing plates have drawbacks such as low precision caused by the flowing-out of a photosensitive resin composition from the edge of the structural body before exposure (curing) (cold flow), and muddiness of the resin composition under humid atmosphere for a long time (moisture-absorption muddiness).

An platemaking processed printing plate has drawbacks such as low reproducibility of fine lines on the printing plate and the chipping of characters or the like on the printing plate caused by wiping off ink adhered to the surface of the printing plate during or after printing.

In order to avoid these drawbacks, various methods have conventionally been proposed regarding photosensitive resin compositions.

For example, Patent Documents 1 and 2 propose to use a styrene-butadiene block copolymer or a styrene-isoprene block copolymer for a thermoplastic elastomer. However, since the molecular weights of these copolymers are small, the chipping resistance of a printing plate is not necessarily sufficient enough.

Patent Documents 4 and 5 propose a block copolymer having a high molecular weight and 3 or more branches combined with a polyfunctional coupling agent. However, the amount of the block copolymer comprising two blocks is not enough, and neither the moldability of a resin composition nor the fine line reproducibility of the printing plate is necessarily enough.

Further, Patent Document 6 proposes a block copolymer having 3 or more branches combined with a polyfunctional coupling agent. However, the chipping resistance of a printing plate is not necessarily enough because of the small molecular weight of the block copolymer. Neither the moldability of a resin composition nor the fine line reproducibility of the printing plate is necessarily enough because of insufficient content of the block copolymer.
[Patent document 1]
   Japanese Patent Application Laid-Open No. 2000-155418
[Patent document 2]
   Japanese Patent Application Laid-Open No. 02-108632
[Patent document 3]
   Japanese Patent Application Laid-Open No. 04-342258
[Patent docmnent 4]
   Japanese Patent Application Laid-Open No. 63-70242
[Patent docutnent 5]
   Japanese Patent Application Laid-Open No. 11-249305
[Patent doculnent 6]
   Japanese Patent Application Laid-Open No. 08-69107

EP1473595A1 discloses a photopolymerizable composition which comprises:
(a) from 20 to 98.9 % by weight, based on the weight of components (a) and (b), of one or more thermoplastic elastomeric block copolymers comprising a thermoplastic elastomeric block copolymer of the formulae

   A-C-A (1)

   or

   (A-C)nX (2)

   wherein each A independently represents a polymer block of predominantly a monovinyl aromatic hydrocarbon having an apparent molecular weight in the range of from 7,000 to 25,000, wherein n is an integer equal to or greater than 2 and wherein X is the residue of a coupling agent, and wherein each C independently represents a substantially random copolymer block (liB) of predominantly isoprene and butadiene in a mutual weight ratio in the range of from 20/80 to 80/20, wherein said polymer block C has a glass transition temperature of at most 0°C (determined according to ASTM E-1356-98), and having a vinyl bond content (the 1,2 and/or 3,4-addition polymerisation of the isoprene and butadiene) in the range of from 5 to 70 mole %, said thermoplastic block copolymer having a poly(monovinyl aromatic hydrocarbon) content in the range of 10 to 45 wt % and having an apparent molecular weight of the complete block copolymer in the range of from 100,000 to 1,500,000,
(b) from 1 to 60 % by weight, based on the weight of components (a) and (b), of one or more photopolymerizable ethylenically unsaturated low molecular weight compounds,
(c) from 0.1 to 10 % by weight, based on the totalpolymerizable composition of one or more polymerization initiators, and optionally,
(d) from 0 to 40 % by weight, based on the total polymerizable compositions of one or more auxiliaries, and flexographic printing plates derived from said photopolymerizable compositions, and flexographic printing relief forms prepared from said plates.
JP 10 287817A discloses a hydrophilic copolymer composition obtained by adding butadiene, ethyl acrylate, phosphoric ethylene methacrylate, phosphoric bis(ethylene methacrylate), styrene, ethylene glycol dimethacrylate, sodium dodecylbenzenesulfonate, potassium persulfate and t-dodecylmercaptan to water, subjecting the mixture to emulsion polymerization to yield a hydrophilic copolymer latex, adding 4,6-bis(octylthiomethyl)-o-cresol to the resultant latex, then adding the latex to an aqueous solution of lauryldiethanolamine to coagulate the above hydrophilic copolymer, and finally, collecting and drying the coagulated product.

EP 0 740 214 discloses a photosensitive composition which can be obtained by kneading 30 weight parts of a C-D-C type block copolymer having a butadiene block/styrene block ratio of 80.2/19.8, a vinyl bond content in the butadiene block of 30.2 % and a weight average molecular weight of 13.4 x 10⁴, 15 weight parts of a tapered A-B type block copolymer having a styrene content of 25 % and an amount of long chains of 82.5 %, 55 weight parts of a hydrophilic copolymer, 55 weight parts of liquid polybutadiene, 10 weight parts of 1,6-hexanediol diacrylate, 10 weight parts of 1,6-hexanediol dimethacrylate and 1 weight part of benzoin methyl ether. This photosensitive composition may be placed between two polyester films and pressed using a pressing machine to give a photosensitive rubber plate.

EP 0 856 772 relates to a photopolymerizable composition for the production of flexographic printing forms for corrugated board printing. Methods disclosed in EP 0 856 772 include the addition of 2,6-di-tertbutyl-4-methyl phenol as an antioxidant.

EP 0 224 442 relates to substituted phenols as stabilizers. Methods disclosed in EP 0 224 442 include the addition of 2,6-di-tertbutyl-4-methyl phenol as a pre-stabilizer to a polybutadiene.

### [Description of the Invention]

The object of the present invention is to provide a photosensitive resin composition that fulfils the following simultaneously:
(1) improvelnent in moldability of the photosensitive resin composition,
(2) improvement in cold flow resistance of the photosensitive structural body before curing,
(3) inhibition of moisture-absorption muddiness,
(4) improvement in fine line (concave and convex lines) reproducibility of the platemaking processed printing plate, and
(5) improvement in chipping resistance.

As a result of extensive studies, the present inventors have found that the use of a novel photosensitive resin composition described below can solve the problems. This has led to the present invention.

Specifically, the present invention is as defined in the appended claims.

The photosensitive resin composition produced according to the method of the present invention can achieve simultaneously improvement in moldability of a photosensitive resin composition, improvement in heat-resistance, improvement in cold flow resistance of the photosensitive structural body before curing, inhibition of moisture-absorption muddiness, improvement in fine line (concave and convex line) reproducibility of the platemaking processed printing plate, and improvement in chipping resistance.

### [Best Mode of Carrying Out the Invention]

Hereafter, the present invention is specifically explained.

The content of a thermoplastic elastomer (a), which is essential to the present invention preferably in the ranges of 10-70 mass parts relative to 100 mass parts of the photosensitive resin composition.

The thermoplastic elastomer (a) is a block copolymer composition that contains a block copolymer (i) having at least one polymer block comprised of a mono-alkenyl aromatic compound wherein the mono-alkenyl aromatic compound accounts for at least 90 wt% of the total weight of the polymer block and at least one polymer block in which butadiene accounts for at least 90 wt% of the total weight of the polymer block, wherein the number average molecular weight (number average molecular weight in terms of polystyrene measured by GPC) of the block copolymer (i) is 50,000-150,000; and a branched block copolymer (ii) having at least two polymer blocks comprised of a mono-alkenyl aromatic compound wherein the mono-alkenyl aromatic compound accounts for at least 90 wt% of the total weight of the two polymer blocks and at least one polymer block in which butadiene accounts for at least 90 wt% of the total weight of the polymer block, wherein the number average molecular weight (number average molecular weight in terms of polystyrene measured by GPC) of the branched block copolymer (ii) is 200,000-350,000.

The term "mainly", as used throughout this specification means that each block may comprise a main monomer and a minute amount of monomers. The monomers contained in a minute amount may be similar to or differrent from the main monomer, and may occupy 10 mass % or less of the total weight of the block copolymer.

The mono-alkenyl aromatic compound in the block copolymer of the present invention includes styrene, p-methyl styrene, tertiary butyl styrene, alpha-methyl styrene, and 1,1-diphenylethylene. Of these, styrene is preferred. These monomers may be used independently or in a combination of two or more.

The amount of the mono-alkenyl aromatic compound unit in the thermoplastic elastomer (a) is 10-28 mass % based on the thermoplastic elastomer (a). It is only when the amount of the mono-alkenyl aromatic compound unit is in this range that the resin composition can exhibit good moldability, fine line reproducibility and chipping resistance.

The content of the block copolymer (i) in the thermoplastic elastomer (a) is 15-50 mass %. The content of 15 mass % or more can acquire moldability and fine line reproducibility of a resin composition. The content of 50 mass % or less is preferred to prevent deterioration in the cold flow-resistance of the photosensitive structural body before curing and the chipping resistance of a platemaking processed printing plate. The more preferred content is 15 to 40 mass %.

The number average molecular weight (number average molecular weight in terms of polystyrene measured by GPC) of the block copolymer (i) in the thermoplastic elastomer (a) is 50,000-150,000. The number average molecular weight of 50,000 or more can acquire cold flow resistance and chipping resistance. From the viewpoint of moldability, the number average molecular weight of 150,000 or less is preferred.

The number average molecular weight (number average molecular weight in terms of polystyrene measured by GPC) of the branched block copolymer (ii) in the thermoplastic elastomer (a) is 200,000-350,000. The number average molecular weight of 200,000 or more can acquire cold flow resistance and chipping resistance.

The branched block copolymer (ii) which constitutes the essential thermoplastic elastomer (a) in the present invention is, for example, represented by the following general formula:

(A-B) n-X, (A-B) n A-X, or (B-A) n B-X.

(wherein A is a polymer block comprised mainly of a mono-alkenyl aromatic compound, B is a polymer block comprised mainly of butadiene, n is an integer of two or more, and X is a residue of a polyfunctional coupling agent that has three or more functional groups.)

The polyfunctional coupling agent with three or more functional groups includes, for example,
epoxy compounds such as epoxidized soybean oil,
alkoxysilane compounds such as trimethoxysilane, triethoxysilane, tetramethoxy silane, and tetrethoxy silane,
tetrachlorosilane, tin tetrachloride, polyhalogenated hydrocarbon compound, carboxylate ester compound, etc.

From the viewpoint of heat-resistance of the thermoplastic elastomer (a) and hygroscopic of a resin composition obtained, the polyfunctional coupling agent is preferably a non-halogen compound, especially preferably an alkoxysilane compound. The coupling agent may be used independently or in the form of a mixture of two or more.

From the viewpoint of easy production of the block copolymer, the thermoplastic elastomer (a) preferably contains the branched block copolymer (ii) represented by (A-B) n - X. It is preferred that the main component in the branched block copolymer (ii) is a trifurcation or tetrafurcation block copolymer having n=3 or 4. A trifurcation structural body is the most preferred with respect to improvement in the moldability of a photosensitive resin composition and the cold flow resistance of the photosensitive structural body before curing.

The amount of 1,2-vinyl bond in the polymer block comprised mainly of butadiene units which is contained in the thermoplastic elastomer (a) is preferably 1-30 mol % from the viewpoint of the heat-resistance of the thermoplastic elastomer (a), and the chipping resistance of the resin composition obtained, more preferably 3-20 mol %, further more preferably 3-25 mol %.

The thermoplastic elastomer (a) of the present invention can be obtained in the form of a polymer composition comprising the block copolymer (i) and the branched block copolymer (ii) by, for example, the following method:
polymerizing styrene in an inert hydrocarbon solvent using an organolithium compound as a polymerization initiator, and subsequently polymerizing butadiene, and if needed repeating these steps, to obtain the block copolymer (i); and then,
adding a specified quantity of the polyfunctional coupling agent in a polymerization system to conduct a coupling reaction.

Alternatively, the thermoplastic elastomer (a) of the present invention can also be obtained by the following method:
polymerizing styrene in an inert hydrocarbon solvent using an organolithium compound as a polymerization initiator, and subsequently polymerizing butadiene to obtain the block polymer (i);
separately polymerizing styrene in an inert hydrocarbon solvent using an organolithium compound as a polymerization initiator, and subsequently polymerizing butadiene, and adding a specified quantity of the polyfunctional coupling agent in a polymerization system to obtain the branched block copolymer (ii); and then
blending the block polymer (i) and the branched block copolymer (ii).

After polymerization, the solutions of block copolymers (i) and (ii) are mixed, followed by adding water, alcohol, acid, etc. to deactivate active species. Or active species in the solution of the block copolymers (i) and (ii) are deactivated separately, followed by mixing the solutions. After that, a polymerization solvent is separated from the obtained mixed solution by steam stripping, etc. and then the solution is dried to obtain the thermoplastic elastomer (a) of the present invention.

The thermoplastic elastomer (a) of the present invention can also be obtained by blending polymers with a roll, etc., which are prepared by separating and drying a polymerization solvent from the solution of the block copolymers (i) and (ii) individually.

In general, from the viewpoint of productivity, the thermoplastic elastomer (a) of the present invention is obtained preferably in the form of a composition comprising the block copolymers (i) and (ii) by polymerizing block copolymer (i), and then adding a specified quantity of a polyfunctional coupling agent into a polymerization system.

An antioxidant (except for BHT (2,6-tert-butyl-p-cresol) is added to the thermoplastic elastomer (a). The antioxidant may be added according to an arbitrary method. For instance, it may be added to a solution after polymerization, or addition kneaded with a roll, etc. after drying.

The antioxidant is at least one compound selected from hindered phenol-based compounds 2,4-bis (n-octyl thiomethyl)-O-cresol, 2,4-bis (n-dodecyl thiomethyl)-O-cresol, 2,4-bis (phenyl thiomethyl)-3-methyl-6-tert-butylphenol, n-octadecyl-3-(3', 5'-di-tert-butyl-4'-hydroxyphenyl) propionate, 2,2'-methylenebis (4-ethyl-6-tert-butylphenol) sulfur-based compounds such as pentaerythritol tetrakis (β-lauryl-thio-propionate), dilauryl-3,3'-thiodipropionate, dimyristyl 3,3'-thiodipropionate, and distearyl-3,3'-thiodipropionate; phosphorus-based compounds such as tris (nonylphenyl) phosphite, cyclic neopentane tetrailbis (octadecyl phosphite), and tris (2,4-di-tert-buthylphenyl) phosphite. These may be used independently or in a mixture of two or more sorts.

The heat-resistance of a photosensitive resin composition is greatly improved by adding at least a kind of compound selected from the group consisting of a hindered phenol-based compound containing sulfur atoms such as 2,4-bis (n-octyl thiomethyl)-O-cresol, 2,4-bis (n-dodecyl thiomethyl)-O-cresol and 2,4-bis (phenyl thiomethyl)-3-methyl-6-tert-butylphenol, a sulfur-based compound and a phosphorus-based compound, more preferably the hindered phenol-based compound, among the above-mentioned compounds.

The photopolymerizable unsaturated compound (b) of the present invention has an unsaturated double bond within a molecular, and any compound can be employed (b) as long as the compound is such that it is in the form of a liquid or solid at working temperature.

The content of the photopolymerizable unsaturated monomer (b) is preferably 0.5 to 30 mass parts based on the 100 mass parts of the composition.

From the viewpoint of high reactivity and good compatibility with various compounds, an acrylic compound and a methacrylic acid compound are used for the photopolymerizable unsaturated monomer (b). From the viewpoint of low toxicity and low corrosion, the above-mentioned (meta) acrylic acid esters are more preferably employed.

Specifically, there are exemplified alkyl (meta) acrylate, cycloalkyl (meta) acrylate, alkyl halide (meta) acrylate, alkoxy alkyl (meta) acrylate, hydroxyalkyl (meta) acrylate, amino alkyl (meta) acrylate, tetrahydrofurfuryl (meta) acrylate, allyl (meta) acrylate, glycidyl (meta) acrylate, benzyl (meta) acrylate, phenoxy (meta) acrylate, alkylene glycol (meta) acrylate, polyoxy-alkylene-glycol (meta) acrylate, alkyl polyol poly (meta) acrylate, etc. More specifically, there are exemplified ethylene glycol (meta) acrylate, tetraethylene glycol (meta) acrylate, hexamethylene (meta) acrylate, nonamethylene (meta) acrylate, methylol propane (meta) acrylate, glycerol (meta) acrylate, pentaerythritol (meta) acrylate, phenoxyethyl (meta) acrylate, phenoxytetraethylene glycol (meta) acrylate, ethoxylated bisphenol A (meta) acrylate, etc. Low-molecular-weight polybutadiene, modified polybutadiene, etc. can be used as both an unsaturated compound and a plasticizer. Specifically, there are exemplified liquid polybutadiene of molecular weight 500-5000, maleic modified polybutadiene, acrylic modified polybutadiene, etc. A maleimide compound can also be used as an unsaturated compound. Specifically, there are exemplified lauryl maleimide, cyclohexyl maleimide, etc.

Furthermore, a polyfunctional unsaturated compound can also be used as the photopolymerizable unsaturated monomer (b). The polyfunctional unsaturated compound is such that an unsaturated compound that has two or more unsaturated double bonds within a molecular. It is preferable that the polyfunctional unsaturated compound is contained at a content of 0.05 to 10 mass parts based on 100 mass parts of the composition.

Specific examples of the polyfunctional unsaturated compound include alkyldi (meta) acrylate, cycloalkyldi (meta) acrylate, halogenation alkyldi (meta) acrylate, alkoxyalkyldi (meta) acrylate, hydroxyalkyldi (meta) acrylate, aminoalkyldi (meta) acrylate, tetrahydrofurfuryldi (meta) acrylate, allyldi (meta) acrylate, glycidyldi (meta) acrylate, benzyldi (meta) acrylate, phenoxydi (meta) acrylate, alkyleneglycoldi (meta) acrylate, polyoxyalkyleneglycoldi (meta) acrylate, alkyl polyol poly (meta) acrylate, etc. More specific examples include diethyleneglycol di(meta) acrylate, tetrethyleneglycol di(meta) acrylate, hexamethylene di(meta) acrylate, nonamethylene di(meta) acrylate, trimethylolpropane tri(meta) acrylate, tricyclodecane di(meta) acrylate, glycerol tri(meta) acrylate, pentaerythritol tetra(meta) acrylate, phenoxyethyl di(meta) acrylate, phenoxytetrethyleneglycol di(meta) acrylate, ethoxylated bisphenol A di(meth) acrylate, etc.

In order to adjust the hardness of a printing plate and resolution, these polyfunctional unsaturated compounds are usually used together with the aforementioned unsaturated compound and incorporated into the composition in advance.

The photopolymerization initiator (c) in the present invention is a compound that absorbs light energy and generates a radical. Various kinds of publicly known compounds can be used as the photopolymerization initiator (c). Various kinds of organic carbonyl compounds, especially aromatic carbonyl compounds are preferred. Specific examples include thioxanthon such as benzophenone, 4,4-bis(diethylamino) benzophenone, t-butyl anthraquinone, 2-ethylanthraquinone, 2,4-diethyl thioxanthon, isopropyl thioxanthon, and 2,4-dichloro thioxanthon; acetophenone such as diethoxy acetophenone, 2-hydroxy-2-methyl-1-phenylpropane 1-one, benzyl dimethyl ketal, 1-hydroxycyclohexyl-phenyl ketone, 2-methyl-2-morpholino (4-thiomethyl phenyl) propan-1-one, 2-benzyl-2-dimethylamino 1-(4-morpholino phenyl)-butanone; benzoin ether such as benzoin methyl ether, benzoin ethyl ether, benzoin iso-propyl ether, and benzoin isobutyl ether; acyl phosphine oxide such as 2,4,6-trimethyl benzoyl diphenyl phosphine oxide, bis (2,6-dimethoxybenzoyl)-2,4,4-trimethyl pentyl phosphine oxide, and bis (2,4,6-trimethyl benzoyl)-phenyl phosphine oxide; methyl benzoyl formate; 1,7-bisacridinyl heptane; 9-phenyl acridine; etc. These may be used independently or in combinations of two or more.

The content of the photopolymerization initiator (c) is preferably 0.1-10 mass parts relative to 100 mass parts of the photosensitive resin composition. The content of 0.1 or more mass parts is preferred with respect to the shaping of fine dots or characters. The content of 10 or less mass parts is preferred with respect to the deterioration of exposure sensitivity due to reduced permeability of active light such as ultraviolet radiation.

Further, a linear type of styrene butadiene block copolymer and a styrene isoprene block copolymer which have three or more blocks may also be used in addition to the above mentioned components essential to the photosensitive resin composition of the present invention. As desired, various auxiliary addition components, for example, a plasticizer, a thermal-polymerization inhibitor, an ultraviolet ray absorbent, an antihalation agent, a light stabilizer, etc.

The plasticizer includes such that is a mobile liquid at ordinary temperature. For example, hydrocarbon oil such as naphthene oil and paraffin oil, liquid polybutadiene, liquid polyisoprene, modified liquid polybutadiene, liquid acrylicnitrile butadiene copolymer, liquid styrene butadiene copolymer, polystyrene with a number average molecular weight of 2,000 or less, sebacic acid ester, phthalic ester, etc. A photopolymerizable reaction group may be imparted to the molecular structural body of these plasticizers.

The method of continuously preparing a lamellar structure by extrusion molding is illustrated. At least one of a thermoplastic elastomer, a photopolymerizable unsaturated monomer and a photopolymerization initiator is weighed and supplied into a self-cleaning type biaxial screw extruder where, melting deaeration is carried out, and subsequently the composition is conveyed into two calendering rolls through a sheet dice and molded.

In this method, it is in accordance with the invention to weigh and supply the thermoplastic elastomer (a) in the first zone of an extruder, and supply other components from two or more supply openings in the subsequent zone to the first zone, to mix the thermoplastic elastomer (a) and the other components for the purpose of further suppressing nonuniformity in kneading. In this case, it is preferable to supply 10-40 mass % of the other components to the first supply opening for more uniform mixing.

Since a photosensitive resin composition is usually sticky, a solvent-soluble thin flexible protection layer (for example, refer to JP 5-13305 B) may be arranged on the resin layer surface to improve contact property with a negative film laminated thereon upon platemaking or to enable recycling of a negative film. The flexible protection layer may be made into a UV shielding layer containing an infrared susceptible substance and selectively subjected to direct engraving with an infrared laser for using the flexible protection layer itself as a negative. In either case, the thin flexible protection layer is removed at the time unexposed parts are washed out after exposure is completed.

When a solvent soluble thin flexible protection layer, for example, a polyamide layer, partially saponified polyvinyl acetate and cellulose ester which are soluble in a washing-out liquid, is arranged on the surface of a photosensitive resin layer, a solution prepared by dissolving polyamide, etc. in a suitable solvent may be directly coated onto the photosensitive resin layer. Alternatively, the solution may be coated onto a film made of, for example, polyester and polypropylene to prepare a protection layer. Thereafter, the protection layer is laminated or press-bonded onto the photosensitive layer to transfer a protection film.

In general, after the photosensitive resin composition is molded into a sheet, a protective film or a support is adhered to the photosensitive resin composition by roll laminations and then heat-pressed. As a result, a photosensitive resin layer with much more sufficient thickness accuracy can be obtained.

An ultraviolet light source used for photo-setting the photosensitive resin layer includes a high-pressure mercury lamp, an ultraviolet fluorescent lamp, a carbon-arc lamp, a xenon lamp, etc. Although a desired relief image can be obtained by exposing a photosensitive resin layer with ultraviolet radiation through a negative film, it is effective to perform full exposure from the support side to make a relief image more stable to the pressure applied upon washing-out of uncured parts. The exposure from the negative film side and the support side may be performed subsequently to the other (no limitation on the exposing order) or simultaneously. From the viewpoint of image reproducibility, it is preferred to perform the exposure from the support side first.

Uncured parts are generally removed by washing with a developing solvent or making an absorption layer absorb after heat melting. A developing solvent used for washing out unexposed parts includes ester such as heptyl acetate and 3-methoxy butyl acetate; hydrocarbons such as petroleum fraction, toluene and decalin; and chlorine-based organic solvents like tetrachloroethylene mixed with alcohols like propanol, butanol and pentanol.

The unexposed parts can be washed out by injection from a nozzle or brushing with a brush. After rinsed and dried, the obtained printing plate is irradiated with a light having a wavelength of not more than 300 nm in wavelength and subjected to post-exposure treatment with a light having a wavelength larger than 300 nm, if needed, to finish.

### [Example]

Hereafter, the present invention will specifically be described referring to Manufacture Examples, Examples and Comparative Examples, but is not limited thereto.

The thermoplastic elastomer (a) obtained in the following Manufacture Examples was analyzed according to the following "(1) Analysis of thermoplastic elastomer", and analyses of moldability of a photosensitive resin composition, cold flow resistance of the photosensitive structural body before curing, inhibition of moisture-absorption muddiness, fine line (concave and convex line) reproducibility and chipping resistance of a platemaking processed printing plate were conducted according to the following "(2) Evaluation method."

### (1) Analysis of thermoplastic elastomer

### 1-1) Styrene content of block copolymer

A styrene content of the block copolymer was calculated from the absorption intensity at 262 nm using a ultraviolet radiation spectrophotometer (trade name, Hitachi UV 200).

### 1-2) Number average molecular weight of branched block copolymer (ii) and composition ratio of block copolymer (i)

A number average molecular weight of the branched block copolymer (ii) and a composition ratio of the block copolymer (b) were computed from chromatogram obtained by GPC (manufactured by Waters Co.; column: combination of three MINIMIX(s) (trade name) manufactured by Polymer Laboratory Co.; solvent: tetrahydrofuran; measurement conditions: temperature of 35 °C, flow rate of 0.4 ml/min, sample concentration of 0.1 weight %, and charge amount of 40 µl) The number average molecular weight is a value obtained by converting standard polystyrene calibration curves (standard samples with a number average molecular weight of 1.54 x 10⁶, 4.1 x 10⁵, 1.10 x 10⁵, 3.5 x 10⁴, 8.5 x 10³ and 1.8 x 10³, manufactured by Waters Co., were used.).

### (2) Evaluation method

### (2-1) Moldability of photosensitive resin composition

Moldability was evaluated visually when a photosensitive resin composition was supplied to a dice with a lip width of 2 mm x 100 mm at a resin temperature of 140 °C and an extrusion rate of 5 kg/h using an extruder ZSK-25 (trade name, manufactured by Werner Pfleiderer Industrielle Backtechnik GmbH),. When the resin composition was smoothly and uniformly molded in the across-the-width direction, the molding was determined as being good. When the surface of the molded article became disadvantageously uneven and irregular due to low flowability, it was determined as being poor.

### (2-2) Cold flow resistance

A 5 cm x 5 cm photosensitive structural body with a thickness of 3 mm was cut out prior to being exposed. The cut-out structural body was allowed to stand with a load of 28 g/cm² applied on the whole surface at 40 °C for 24 hours to measure the change in thickness. When the thickness reduction rate of the photosensitive structural body exceeded 3.0% in this measurement, printing plates might be disadvantageously deformed when the photosensitive structural body is stored or transported. Thus, the thickness reduction rate over 3.0 % was considered to be poor.

### (2-3) Moisture-absorption muddiness resistance

A 5 cm x 5 cm photosensitive structural body with a thickness of 3 mm prior to being exposed was cut out. The turbidity of the cut-out structural body after being allowed to stand for 7 days at 40 °C in 80 %humidity (RH) was measured using a haze meter 1001D (manufactured by Nihon Denshoku Kogyo, trade name). When turbidity exceeded 25% under the humidity, the photosensitive structural body became muddy so that light scattered upon exposure and reproducibility deteriorated disadvantageously. Thus, the turbidity over 25 % was considered as being poor.

### (2-4) Fine line (concave and convex line) reproducibility of printing plate

The shapes of 500 µm concave and convex fine lines of relief image were evaluated using a microscope. The case that grooves of concave fine lines were deep and convex fine lines were sharp and not thick was considered as being good. The case that grooves of concave fine lines were shallow and convex fine lines were non-sharp and thick was considered as being poor.

### (2-5) Chipping resistance

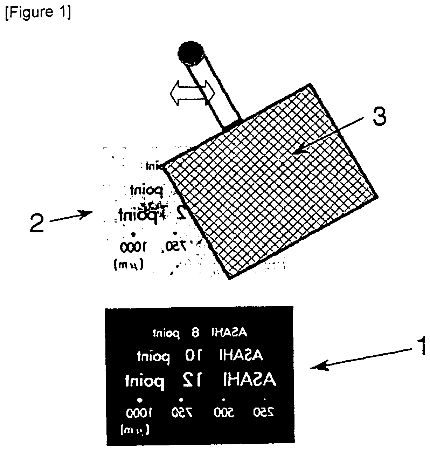

For evaluation of chipping resistance of a printing plate, a sample printing plate 2 was prepared using a negative film 1 with 8 to 12 point characters as shown in Fig. 1. The printing plate 2 was rubbed from side to side 300 times with a contact body 3 using a NP type printing durability tester (manufactured by Niimura Printing Co., Ltd., trade name; contact body: cloth, size: 8 cm x 6 cm, load: 1 kg) to observe breakage level of the characters with a microscope. The case that the characters were not broken was considered as being good. The case that the characters were broken was considered as being poor. A printing plate with poor image reproducibility was not evaluated.

### Manufacture Example (Synthesis of thermoplastic elastomer (a))

### (Manufacture Examples 1-3 and Comparative Manufacture Examples 2 and 3)

After a stainless steel reactor having an inner volume of 10 liters equipped with a stirrer and a jacket was purged with nitrogen, 6,500 g of cyclohexane, 1.2 g of tetrahydrofuran and 220 g of styrene were charged and the temperature of the content was set at about 55 °C by flowing warm water through the jacket. Then, an n-butyl lithium cyclohexane solution (pure content of 1.25 g) was added to start styrene polymerization.

Three minutes after the styrene polymerization was nearly completed, 780 g of butadiene (1,3-butadiene) was added to resume the polymerization. Four minutes after butadiene was polymerized almost completely and reached the highest temperature of about 90 °C, 0.92 g of tetramethoxy silane was added as a coupling agent to conduct a coupling reaction. The inside of the reactor was continuously agitated by the agitator from immediately after charging the styrene until the coupling agent was placed in the reactor.

The solution of the obtained block copolymer was discharged and 10 g of water was added thereto. After agitation, 3.0 g of n-octadecyl-3-(3',5'di-tert-butyl-4'-hydroxyphenyl) propionate and 1.5 g of 2,4-bis(n-octyl thiomethyl)-O-cresol were added. The obtained solution was subjected to steam stripping to remove the solvent and obtain a water-containing crumb. Subsequently, the water-containing crumb was dehydration dried with a hot calender roll to obtain a sample of the thermoplastic elastomer (a) that has analytical values of Manufacture Example 1 shown in Table 1.

Samples of the thermoplastic elastomer (a) having analytical values of Manufacture Examples 2 and 3 and Comparative Manufacture Examples 2 and 3 shown in Table 1 were obtained by the same method as in Manufacture Example 1 except that the amounts of styrene, n-butyl lithium and tetramethoxy silane were changed.

### (Comparative Manufacture Example 1)

After a stainless steel reactor having an inner volume of 10 liters equipped with a stirrer and a jacket was purged with nitrogen, 6,500 g of cyclohexane, 1.2 g of tetrahydrofuran and 300 g of styrene were charged and the temperature of the content was set at about 55 °C by flowing warm water through the jacket. Then, an n-butyl lithium cyclohexane solution (pure content of 1.45 g) was added to start styrene polymerization.

Three minutes after the styrene polymerization was nearly completed, 700 g of butadiene (1,3-butadiene) was added to resume the polymerization. Four minutes after the butadiene was almost completely polymerized and reached the highest temperature of about 90 °C, 0.86 g of tetrachlorosilane was added as a coupling agent to conduct a coupling reaction. The inside of the reactor was continuously agitated by the agitator from immediately after charging styrene till the coupling agent in the reactor.

The solution of the obtained block copolymer was discharged and 10 g of water was added thereto. After agitation, 3.0 g of n-octadecyl-3-(3',5'di-tert-butyl-4'-hydroxyphenyl) propionate and 1.5 g of 2,4-bis(n-octyl thiomethyl)-O-cresol were added. The obtained solution was subjected to steam stripping to remove the solvent and obtain a water-containing crumb. Subsequently, the water-containing crumb was dehydration dried with a hot calender roll to obtain a sample of the thermoplastic elastomer (a) having analytical values of Comparative Manufacture Example 1 shown in Table 1.

### (Comparative Manufacture Example 4)

After a stainless steel reactor having an inner volume of 10 litters equipped with a stirrer and a jacket was purged with nitrogen, 6,500 g of cyclohexane, 1.2 g of tetrahydrofuran and 300 g of styrene were charged and the temperature of the content was set at about 55 °C by flowing warm water through the jacket. Then, n-butyl lithium cyclohexane solution (pure content of 0.96 g) was added to start styrene polymerization.

Three minutes after the styrene polymerization was nearly completed, 700 g of butadiene (1,3-butadiene) was added to resume the polymerization. Four minutes after butadiene was almost completely polymerized and reached the highest temperature of about 90 °C, 1.25 g of dibromoethane was added as a coupling agent to conduct coupling reaction. The inside of the reactor was continuously agitated by the agitator from immediately after charging styrene till the coupling agent in the reactor.

The solution of the obtained block copolymer was discharged and 10 g of water was added. After agitation, 3.0 g of n-octadecyl-3-(3',5 'di-tert-butyl-4'-hydroxyphenyl) propionate and 1.5 g of 2,4-bis(n-octyl thiomethyl)-o-cresol were added. The obtained solution was subjected to steam stripping to remove the solvent and obtain a water-containing crumb. Subsequently, the water-containing crumb was dehydration dried with a hot calender roll to obtain a sample of the thermoplastic elastomer (a) having analytical values of Comparative Manufacture Example 4 shown in Table 1.

### (Examples 1-3 and Comparative Examples 1-4)

### (1) Preparation of a photosensitive resin composition and photosensitive structural body

A photosensitive resin compositions was obtained by mixing 55 mass parts each of the styrene butadiene block copolymers of Manufacture Examples 1-3 and Comparative Manufacture Examples 1-4 with 25 mass parts of liquid rubber LIR-305 (trade name, manufactured by Kuraray Co.), 10 mass parts of hydrocarbon smoil P350P (trade name, manufactured by Matsumura Oil Co., Ltd.), 3.0 mass parts of 1,9-nonanediol diacrylate, 5.0 mass parts of 1,9-nonanediol dimethacrylate, 1.5 mass parts of 2,2-dimethoxy-2-phenyl acetophenone and 0.5 mass parts of 2,6-di-t-butyl-p-cresol for 60 minutes at 140 °C using a kneader. The obtained photosensitive resin composition was interposed between a 125 µm thick polyester film support coated with an adhesive containing a thermoplastic elastomer and a 100 µm thick polyester cover sheet having a 4 µm thick polyamide layer, and pressed using a 3 mm spacer by a pressing machine at 130 °C at a pressure of 200 kg/cm² for 4 minutes to mold a photosensitive structural body for a flexographic printing plate.

### (2) Preparation of a flexographic printing plate

The cover sheet of the photosensitive resin structural body for flexographic printing plates obtained in the above (1) was peeled off. A negative film was adhered on the polyamide protection layer on the photosensitive resin layer. Full exposure was conducted first on the surface of the support side (back exposure) at 300 mJ/cm² using an ultraviolet fluorescent lamp having a center wavelength of 370 nm on an exposing machine AFP-1500 (trade name, manufactured by Asahi Kasei Chemicals Corp.). Successively, image-exposure (relief exposure) was conducted at 6,000 mJ/cm² through the negative film.

The exposure intensity was measured with a UV-35 filter using a UV illuminometer MO-2 type machine manufactured by ORC Manufacturing Co., Ltd. The intensity of the ultraviolet rays irradiated from the lamp on the lower side, where the back exposure was conducted, measured on a glass plate was 10.3 mW/cm². The intensity of the ultraviolet rays irradiated from the lamp on the upper side, where the relief exposure was conducted, was 12.5 mW / cm². Then, the obtained plate was attached with a double-sided adhesive tape on a rotating cylinder of a developing machine AFP-1500 (trade name, manufactured by Asahi Kasei Chemicals Corp.), developed using 3-methoxybutyl acetate as a developing solution at a liquid temperature of 25 °C for 5 min, and dried at 60°C for 2 hours.

Thereafter, as the post-exposure, the whole surface of the plate was exposed to 2,000 mJ/cm² using a germicidal lamp having a center wavelength of 254 nm, and successively to 1,000 mJ/cm² using an ultraviolet fluorescent lamp to obtain a flexographic printing plate. Here, the post-exposure light amount by the germicidal lamp was calculated from the illuminance measured using the MO-2 type machine with the UV-25 filter.

The evaluation test results of the moldability of the photosensitive resin composition obtained in Examples 1-3 and Comparative Examples 1-4, the cold flow resistance and the inhibition of moisture-absorption muddiness of the photosensitive structural body before curing, and the fine line (concave and convex line) reproducibility and the chipping resistance of the platemaking processed printing plate are listed in Table 1, items 1) - 5).

As seen from the results, when the amount of mono-alkenyl aromatic compounds in the thermoplastic elastomer (a) exceeds 28 mass parts, the moldability is reduced and the fine line reproducibility and chipping resistance are deteriorated. When the content of the block copolymer (b) is less than 10 mass %, the moldability or fine line reproducibility is deteriorated.

Further, when the molecular weight of the branched block copolymer (ii) is less than 200,000, the cold flow resistance or chipping resistance is deteriorated.

**[Table 1]**

| | | Ex. 1 | Ex. 2 | Ex. 3 | Comp. Ex. 1 | Comp. Ex. 2 | Comp. Ex. 3 | Comp. Ex. 4 |
|---|---|---|---|---|---|---|---|---|
| Styrene content in thermoplastic elastomer (a) | (mass %) | 22 | 24 | 18 | 30 | 22 | 22 | 30 |
| Amount of block copolymer (i) | (mass %) | 18 | 15 | 15 | 9 | 9 | 18 | 15 |
| Molecular weight of block copolymer (ii) | (x 10⁴) | 27 | 22 | 31 | 27 | 27 | 18 | 19 |
| Number of coupling functional group in (ii) | (n) | 3 | 3 | 3 | 4 | 3 | 3 | 2 |
| 1) Moldability | Judgment | Good | Good | Good | Poor | Poor | Good | Good |
| 2) Cold flow resistance | (%) | 1.2 | 1.3 | 2.3 | 1.2 | 1.3 | 4.5 | 3.8 |
| | Judgment | Good | Good | Good | Good | Good | Poor | Poor |
| 3) Moisture-absorption muddiness resistance | (%) | 15 | 13 | 14 | 35 | 17 | 15 | 40 |
| | Judgment | Good | Good | Good | Poor | Good | Good | Poor |
| 4) Fine line reproducibility | Judgment | Good | Good | Good | Poor | Poor | Good | Good |
| 5) Chipping resistance | Judgment | Good | Good | Good | Poor | Good | Poor | Poor |

### (Examples 4 and 5)

In Example 4, the same thermoplastic elastomer as in Example 1 was weighed and charged in the first zone of the biaxial screw extruder. In Example 5, a thermoplastic elastomer prepared by adding the stabilizer shown in Table 2, instead of the antioxidant employed in Manufacture Example 1 of Example 1 was weighed and charged in the first zone of the biaxial screw extruder. The other components excluding a thermoplastic elastomer from the same composition of the resin composition of Examples 1-3 and Comparative Examples 1-4 were charged to two supply openings of the following zone, and the thermoplastic elastomer (a) and other components were mixed. As a result, although the performance of a plate prepared using the mixture at an early stage was equivalent, the time that the gel did not dissolve in the solution discharged from the dice following to the biaxial screw extruder generated became considerably short in Example 5 where 2,6-tert-butyl-p-cresol was used, compared with Example 4, so that the frequency of cleaning the dice or pipe increased.

**[Table 2]**

| | | Example 4 | Example 5 |
|---|---|---|---|
| Antioxidant added in the (a) (see manufacture example) | | | |
| n-octadecyl-3-(3',5'di-tert-butyl-4'-hydroxyphenyl) propionate | | 3.0 g | |
| 2,4-bis(n-octyl thiomethyl)-o-cresol | | 1.5 g | |
| 2,6-tert-butyl-p-cresol | | | 4.5 g |
| Time until gel generated | | 30 hours | 3 hours |
| 1) Moldability | Judgment | Good | Good |
| 2) Cold flow resistance | (%) | 1.2 | 1.1 |
| | Judgment | Good | Good |
| 3) Moisture-absorption muddiness | (%) | 15 | 16 |
| | Judgment | Good | Good |
| 4) Fine line reproducibility | Judgment | Good | Good |
| 5) Chipping resistance | Judgment | Good | Good |

### [Brief Description of Drawings]

[Figure 1]
Figure 1 shows a conceptual diagram of plate wiping test.

## Claims

1. A production method of a photosensitive resin composition comprising a thermoplastic elastomer (a), a photopolymerizable unsaturated monomer (b), and a photopolymerization initiator (c) as essential ingredients, wherein the thermoplastic elastomer (a) is a block copolymer composition containing a block copolymer (i) having at least one polymer block comprised of a mono-alkenyl aromatic compound wherein the mono-alkenyl aromatic compound accounts for at least 90 wt% of the total weight of the polymer block and at least one polymer block in which butadiene accounts for at least 90 wt% of the total weight of the polymer block, and a branched block copolymer (ii) having at least two polymer blocks comprised of a mono-alkenyl aromatic compound wherein the mono-alkenyl aromatic compound accounts for at least 90 wt% of the total weight of the two polymer blocks and at least one polymer block in which butadiene accounts for at least 90 wt% of the total weight of the polymer block;
the amount of the mono-alkenyl aromatic compound unit in the thermoplastic elastomer (a) is 10-28 mass %; the amount of the block copolymer (i) in the thermoplastic elastomer (a) is 15-50 mass %; and the number average molecular weight (number average molecular weight in terms of polystyrene measured by GPC) of the branched block copolymer (ii) is 200,000-350,000;
wherein the thermoplastic elastomer (a) contains an antioxidant (except for BHT (2,6-tert-butyl-p-cresol), wherein the antioxidant is at least one compound selected from the group consisting of 2,4-bis(n-octyl thiomethyl)-O-cresol, 2,4-bis(n-dodecyl thiomethyl)-O-cresol, 2,4-bis(phenyl thiomethyl)-3-methyl-6-tert-butylphenol, a sulfur-based compound, and a phosphorus-based compound,
which method comprises adding the antioxidant to the thermoplastic elastomer (a) and weighing the thermoplastic elastomer (a) and supplying it to the first zone of a screw extruder, supplying other components to two or more supply openings of the zone following the first zone, and mixing the thermoplastic elastomer (a) and the other components.

2. The method of claim 1, wherein wherein the amount of 1,2-vinyl bonds in the polymer block in which butadiene accounts for at least 90 wt% of the total weight of the polymer block in the thermoplastic elastomer (a) is 1- 30 mol%.

3. The method according to claim 1 or 2, wherein the thermoplastic elastomer (a) is prepared using a non halogen-based polyfunctional coupling agent.

4. The method according to any one of claims 1 to 3, wherein the main component of the branched block copolymer (ii) is a trifurcation block copolymer.

5. The method according to claim 1, wherein the antioxidant is a hindered phenol-based compound.

## Patentansprüche

1. Herstellungsverfahren für eine lichtempfindliche Harzzusammensetzung, umfassend ein thermoplastisches Elastomer (a), ein photopolymerisierbares ungesättigtes Monomer (b) und einen Photopolymerisationsinitiator (c) als wesentliche Bestandteile, wobei es sich bei dem thermoplastischen Elastomer (a) um eine Blockcopolymerzusammensetzung handelt, die ein Blockcopolymer (i) mit mindestens einem Polymerblock aus einer monoalkenylaromatischen Verbindung, wobei die monoalkenylaromatische Verbindung mindestens 90 Gew.-% des Gesamtgewichts des Polymerblocks ausmacht, und mindestens einem Polymerblock, in dem Butadien mindestens 90 Gew.-% des Gesamtgewichts des Polymerblocks ausmacht, und ein verzweigtes Blockcopolymer (ii) mit mindestens zwei Polymerblöcken aus einer monoalkenylaromatischen Verbindung, wobei die monoalkenylaromatische Verbindung mindestens 90 Gew.-% des Gesamtgewichts der zwei Polymerblöcke ausmacht, und mindestens einem Polymerblock, in dem Butadien mindestens 90 Gew.-% des Gesamtgewichts des Polymerblocks ausmacht, enthält;
die Menge der Einheit der monoalkenylaromatischen Verbindung in dem thermoplastischen Elastomer (a) 10-28 Massen-% beträgt; die Menge des Blockcopolymers (i) in dem thermoplastischen Elastomer (a) 15-50 Massen-% beträgt und das zahlenmittlere Molekulargewicht (zahlenmittleres Molekulargewicht in Bezug auf Polystyrol, gemessen durch GPC) des verzweigten Blockcopolymers (ii) 200.000-350.000 beträgt;
wobei das thermoplastische Elastomer (a) ein Antioxidans (mit Ausnahme von BHT (2,6-tert-Butyl-p-kresol)) enthält, wobei es sich bei dem Antioxidans um mindestens eine Verbindung aus der Gruppe bestehend aus 2,4-Bis(n-octylthiomethyl)-O-kresol, 2,4-Bis(n-dodecylthiomethyl)-O-kresol, 2,4-Bis(phenylthiomethyl)-3-methyl-6-tert-butylphenol, einer auf Schwefel basierenden Verbindung und einer auf Phosphor basierenden Verbindung handelt,
bei dem man das Antioxidans zu dem thermoplastischen Elastomer (a) gibt und das thermoplastische Elastomer (a) wiegt und der ersten Zone eines Schneckenextruders zuführt, andere Komponenten zwei oder mehr Zuführungs-öffnungen der auf die erste Zone folgenden Zone zuführt und das thermoplastische Elastomer (a) und die anderen Komponenten mischt.

2. Verfahren nach Anspruch 1, wobei die Menge von 1,2-Vinylbindungen in dem Polymerblock, in dem Butadien mindestens 90 Gew.-% des Gesamtgewichts des Polymerblocks ausmacht, in dem thermoplastischen Elastomer (a) 1 bis 30 Mol-% beträgt.

3. Verfahren nach Anspruch 1 oder 2, wobei das thermoplastische Elastomer (a) unter Verwendung eines nicht auf Halogen basierenden polyfunktionellen Kupplungsmittels hergestellt wird.

4. Verfahren nach einem der Ansprüche 1 bis 3, wobei es sich bei der Hauptkomponente des verzweigten Blockcopolymers (ii) um ein dreizweigiges Blockcopolymer handelt.

5. Verfahren nach Anspruch 1, wobei es sich bei dem Antioxidans um eine gehinderte Verbindung auf Phenol-Basis handelt.

## Revendications

1. Procédé de production d'une composition de résine photosensible comprenant un élastomère thermoplastique (a), un monomère insaturé photopolymérisable (b), et un initiateur de photopolymérisation (c) comme ingrédients essentiels, l'élastomère thermoplastique (a) étant une composition de copolymères séquencés contenant un copolymère séquencé (i) ayant au moins un bloc polymère composé d'un composé aromatique mono-alcénylique, le composé aromatique mono-alcénylique représentant au moins 90 % en poids du poids total du bloc polymère, et au moins un bloc polymère dans lequel le butadiène représente au moins 90 % en poids du poids total du bloc polymère, et un copolymère séquencé ramifié (ii) ayant au moins deux blocs polymères composés d'un composé aromatique mono-alcénylique, le composé aromatique mono-alcénylique représentant au moins 90 % en poids du poids total des deux blocs polymères, et au moins un bloc polymère dans lequel le butadiène représente au moins 90 % en poids du poids total du bloc polymère ;
la quantité du motif de composé aromatique mono-alcénylique dans l'élastomère thermoplastique (a) étant de 10 à 28 % en masse ; la quantité du copolymère séquencé (i) dans l'élastomère thermoplastique (a) étant de 15 à 50 % en masse ; et le poids moléculaire moyen en nombre (poids moléculaire moyen en nombre exprimé en polystyrène mesuré par CPG) du copolymère séquencé ramifié (ii) étant de 200 000 à 350 000 ; l'élastomère thermoplastique (a) contenant un antioxydant (excepté pour le BHT (2,6-tert-butyl-p-crésol), l'antioxydant étant au moins un composé choisi dans le groupe constitué par le 2,4-bis(n-octyl thiométhyl)-O-crésol, le 2,4-bis(n-dodécyl thiométhyl)-O-crésol, le 2,4-bis(phényl thiométhyl)-3-méthyl-6-tert-butylphénol, un composé à base de soufre, et un composé à base de phosphore,
lequel procédé comprend l'ajout de l'antioxydant à l'élastomère thermoplastique (a) et le pesage de l'élastomère thermoplastique (a) et l'alimentation de celui-ci à la première zone d'une extrudeuse à vis, l'alimentation d'autres composants à deux ouvertures d'alimentation ou plus de la zone suivant la première zone, et le mélange de l'élastomère thermoplastique (a) et des autres composants.

2. Procédé selon la revendication 1, la quantité de liaisons 1,2-vinyle dans le bloc polymère dans lequel le butadiène représente au moins 90 % en poids du poids total du bloc polymère dans l'élastomère thermoplastique (a) étant de 1 à 30 % en moles.

3. Procédé selon la revendication 1 ou 2, l'élastomère thermoplastique (a) étant préparé en utilisant un agent de couplage polyfonctionnel non basé sur un halogène.

4. Procédé selon l'une quelconque des revendications 1 à 3, le composant principal du copolymère séquencé ramifié (ii) étant un copolymère séquencé à trois ramifications.

5. Procédé selon la revendication 1, l'antioxydant étant un composé à base de phénol stériquement encombré.
